**Europäisches Patentamt**

**European Patent Office**

**Office européen des brevets**

(11) Publication number : **0 492 311 B1**

# EUROPEAN PATENT SPECIFICATION

(45) Date of publication of patent specification :
**26.04.95 Bulletin 95/17**

(51) Int. Cl.⁶ : **G01R 31/00,** G01R 19/00,
**H02H 11/00, H03K 17/00**

(21) Application number : **91121398.1**

(22) Date of filing : **12.12.91**

(54) **Device for sensing and identifying defects in an electrical power supply circuit.**

(30) Priority : **21.12.90 FR 9016095**

(43) Date of publication of application :
**01.07.92 Bulletin 92/27**

(45) Publication of the grant of the patent :
**26.04.95 Bulletin 95/17**

(84) Designated Contracting States :
**DE GB IT**

(56) References cited :
**EP-A- 0 287 886
EP-A- 0 418 665**

(56) References cited :
**FR-A- 2 509 925
FR-A- 2 602 620
FR-A- 2 629 284
GB-A- 2 025 101**

(73) Proprietor : **Siemens Automotive S.A.
Avenue du Mirail, B.P. 1149
F-31036 Toulouse Cédex (FR)**

(72) Inventor : **Simon, Marc Raymond George
210 bis Chemin Ramelet-Moundi
F-31170 Tournefeuille (FR)**

(74) Representative : **Fuchs, Franz-Josef, Dr.-Ing.
Postfach 22 13 17
D-80503 München (DE)**

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

The present invention relates to a device for detecting and discriminating between faults in an electrical power supply circuit and, more particularly, to such a device associated with a circuit supplying power to a load connected between a source of electrical energy and one terminal of an electronic switch controlling the passage, in that load, of an electrical current delivered by that source.

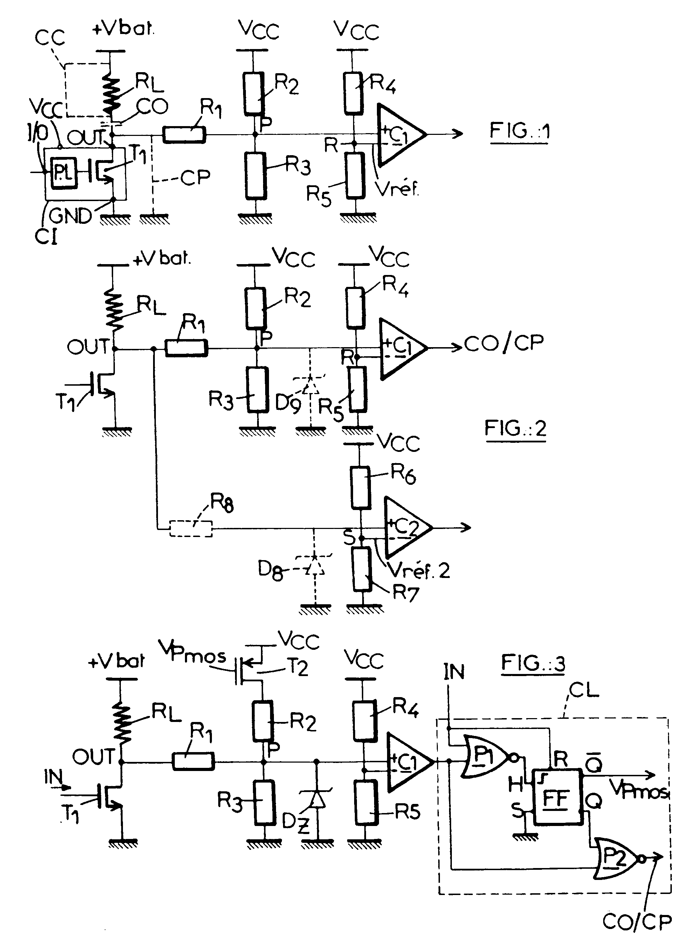

There are currently, notably in automobile electronics, "smart" power integrated circuits used to control the electrical supply to loads such as the coils of electromagnets or solenoid valves, for example. Such an integrated circuit CI (see Figure 1 of the attached drawing) consists of a "power" transistor $T_1$, of the NMOS type, for example, for controlling the passage of a high current in the load $R_L$ and a part PL supplied with a small current for processing the logic signals used on the one hand for the control of the power transistor and, on the other hand, for the detection of faults in the circuit supplying the load.

The circuit CI, whose circuit diagram is at Figure 1, is of the type designed for connection to the "neutral" terminal of the load $R_L$ while the other terminal of the load is connected to a source of electrical energy $+ V_{bat}$ which, in automobile electronics, is a battery of, for example, +12 volts, the positive terminal of this battery constituting the "live" terminal of the circuit.

It will be noticed that, in the circuit CI of this type, there is no pin directly supplied by the $+ V_{bat}$ voltage. The circuit CI thus consists of at least one "OUT" pin for connection to the load $R_L$, a GND pin for connection to an earth, a $V_{CC}$ pin for connection to a circuit supply voltage source and an I/O pin for the inputting of control signals and, optionally, the outputting of the "diagnostic" signals, for example.

Three types of faults are liable to affect the control of the supply to the load $R_L$. These are drawn in dotted lines on Figure 1. The load $R_L$ may be short-circuited (CC fault), or cut off from the transistor $T_1$ by an open circuit (CO) fault in the supply circuit (CO fault). Moreover, this transistor may itself be short-circuited to earth which produces a fault where the supply to the load is permanently on (CP fault).

Devices are known which permit the appearance of these faults to be detected, notably in load control circuits used in automobile electronics. These known devices operate by measuring the current I in the transistor $T_1$ and/or the voltage V on the drain of this transistor. It is thus that a short circuit (CC) of the load is detected, while the transistor $T_1$ is conducting ("ON" state), by comparing either the current I with a predetermined current $I_{MAX}$, or the voltage on the drain of the transistor with a threshold voltage $V_s$ of a value slightly higher than that defined by the product:

$$R_{DSONMAX} \times I_{MAX}$$

where $R_{DSONMAX}$ is the maximum resistance of the drain-source circuit of the transistor $T_1$ in the conducting state.

In the same way, it is easy to detect a fault of the CO or CP type by measuring the current in the transistor in the ON state, this current then being nil despite the transistor being in the conducting state. On the other hand, it is difficult to discriminate between the CO fault and the CP fault, the measurements of the current I taken when the transistor is in its conducting state or when it is in its nonconducting ("OFF" state), giving nil values in both cases. When the transistor is not conducting, the measurement of the drain voltage V in the open-circuit case is complicated by the fact that the drain of the transistor is then in the high impedance state.

It is, however, essential, in certain situations, to identify a fault as being either a CO fault or a CP fault. Thus, for example, taking the case of the control of a solenoid valve permitting the short-circuiting of the supply of pressurised brake fluid to a wheel brake, in a motor vehicle wheel anti-lock device, a CO fault is seen to disable the anti-lock feature of the braking circuit, a feature which usually overrides the normal operation of the circuit, which thus maintains a braking capacity available to the driver. On the other hand, in the case of a permanently ON command (CP) to the solenoid valve, the wheel brake no longer receives pressurised brake fluid and all braking of the wheel becomes impossible, which poses a grave danger for the driver of the vehicle.

To overcome the difficulties mentioned above, which result from the high impedance state of the drain of the transistor when it is nonconducting, a bleed resistor might be installed from the drain either to earth as disclosed in GB-A-2 025 101, but then discriminating between CO and CP becomes impossible, or to the $V_{cc}$ voltage which makes discriminating between CO and normal operation hazardous if $V_{cc}$ is little different from $+V_{bat}$.

To resolve the doubt, it was proposed to detect, without discrimination, the presence of a CO or CP fault with the transistor $D_1$ in the ON state, then to identify the fault with the transistor in the OFF state, using, for example, a bleed resistor to $V_{cc}$ on the drain of the transistor, as indicated above. It was also proposed i.e. in EP-A-0418665 to use a dynamic commutation which, when it is applied to an inductive load gives rise, during normal operation, to the development of a voltage much higher than $+ V_{bat}$ at the terminals of the load, a situation which can be verified by the passage of a current in a Zener "clamp" diode.

It thus appears that, according to the prior art, the CO/CP doubt can be resolved, either by the taking of the two measurements (ON/OFF sequence), or, in the case of inductive loads, a single one.

The present invention aims to produce a device for detecting and discriminating between CO or CP faults in an electrical load control circuit, which does not present these drawbacks or limitations.

The present invention also aims to produce such a device associated with a "smart" power circuit without a in for the $V_{bat}$ voltage, as is the case for those which are connected to the neutral point of the load.

The present invention also aims to produce such a device which lends itself to integration.

The present invention equally aims to produce such a device consisting, moreover, of means for distinguishing a normal state from an abnormal state in the supply to the load, without the necessity to commutate this supply to make this distinction.

These goals are achieved, along with others which will become apparent on reading the description which follows, with a device for detecting and discriminating between faults in the operation of a circuit supplying electric power to a load connected between a source of electrical energy and one terminal of an electronic switch controlling the passage of a current in that load and through the switch, towards an earth connected to another terminal of the switch, this device comprising means for detecting, in the absence of a load supply on command, an abnormal state in the circuit supplying that load and means for then identifying a fault resulting from an open circuit in the supply circuit or a fault resulting from a short-circuit of the switch, which bring about a condition where the supply to the load is permanently on. According to the invention, these means of identification comprise a resistor connected between the common terminal of the load and the switch and the midpoint of a resistor bridge connected between a voltage source ($V_{CC}$) and earth, and a comparator for comparing the voltage at the midpoint of the bridge with a reference voltage in such a way as to diagnose the possible presence of an open circuit fault or permanently on fault in the circuit, according to the value of the voltage at the midpoint of the bridge compared with the reference voltage.

The switch forms part of a "smart" power circuit supplied by the voltage source ($V_{CC}$).

The device comprises, moreover, a second resistor bridge connected between the voltage source ($V_{CC}$) and earth, the voltage at the midpoint of this bridge defining the reference voltage, the resistors of the bridge being adjusted such that this voltage is between those which are observed at the midpoint of the first bridge when the switch is non-conducting, in the presence of an open circuit fault and of a permanently on fault, respectively.

As will be seen below, the device according to the invention is suitable for integration while preserving satisfactory precision.

According to a first embodiment of the device according to the invention, the means for detecting an abnormal state in the power supply circuit comprise means for comparing, while the switch is non-conducting, the voltage $V_{OUT}$ of the terminal common to this switch and the load, with a second reference voltage in order to deduce from the value of the voltage $V_{OUT}$, compared with this second reference voltage, a presence or an absence of an open circuit or permanently on fault in the load supply circuit.

In a second embodiment of the invention, the device comprises means for detecting the existence of a fault, which are integrated with the means used to identify the fault as open circuit or permanently on.

Other features and advantages of the device according to the invention will become apparent on reading the description which follows and on examining the attached drawing, in which :

- Figure 1 is a diagram illustrating the principles of operation and general embodiment of the device for detecting and discriminating between faults according to the invention,
- Figure 2 is a diagram of a first detailed embodiment of the device according to the invention, and
- Figure 3 is a diagram of a second detailed embodiment of the device according to the invention.

Reference is made to Figure 1 of the attached drawing in which the diagram shown of the device according to the invention is associated with a "smart" power circuit described previously in the present description. The device is intended to distinguish between an open circuit (CO) fault and a permanently on (CP) fault and must thus be supplemented by means which make it possible to detect a short-circuit (CC) in the load ($R_L$) to ensure the detection of the set of principal faults which can affect the operation of this load. Many means are known for detecting a short-circuit in a load and the choice of this or that method is therefore left to the person skilled in the art.

In order to distinguish an open circuit (CO) fault from a permanently on (CP) fault, the device according to the invention comprises a resistor $R_1$ connected between the "neutral" point of the load $R_L$ and the point P, the middle of the resistor bridge $R_2$, $R_3$ connected between a voltage source $V_{cc}$ and earth. The device may comprise a second resistor bridge $R_4$, $R_5$ connected between this same voltage source and earth in order to define at its mid-point R a reference voltage ($V_{ref}$) which supplies the negative input of a comparator $C_1$. The positive input of this comparator is connected to the midpoint P of the first resistor bridge $R_2$, $R_3$.

The device according to the invention is more particularly intended to be associated with an "smart" power circuit temporarily switching the supply to a load, the passage of a current in the latter being prevented most of the time by the circuit. By way of example, this is the case when the load consists of the coil of a "release" solenoid valve in a braking circuit for the wheels of a motor vehicle, equipped with an anti-lock device for these wheels. Thus it is during the transistor $T_1$ off time that the distinction between CO/CP is made according to the invention by the mechanism explained below.

Assume, for example, that the load supply circuit is open circuit (CO fault). The resistor $R_1$ is therefore "floating" and the voltage $V_{P1}$ at the midpoint P of the first resistor bridge $R_2$, $R_3$ is equal to :

$$V_{P1} = [R_3/(R_2 + R_3)] \cdot V_{CC}$$

Assuming now that, while the transistor $T_1$ is off, there is a permanently on (CP) supply condition to the load $R_L$, the resistor $R_1$ is then connected to earth, in parallel with the resistor $R_3$. The voltage $V_{p2}$ at the midpoint P of the resistor bridge $R_2$, $R_3$ is then found from the expression:

$$V_{P2} = \frac{R_1 R_3}{R_2 R_1 + R_2 R_3 + R_1 R_3} \cdot V_{CC}$$

The above two expressions for the voltage at P make it clear that all the voltages are referenced to the voltage $V_{CC}$ of the supply to the circuit CI. It is thus possible to distinguish a CO fault from a CP fault without having recourse, according to the prior art, to a supply to the bridge by the voltage + $V_{bat}$. The device according to the invention may thus be integrated into the circuit CI without fitting a pin for + $V_{bat}$ to it, which is particularly advantageous when the circuit is designed to control the load $R_L$ through its "neutral" terminal. By correctly adjusting the voltage $V_{ref}$ by setting of the resistors $R_4$, $R_5$ it will be possible to detect the voltages $V_{p1}$ and $V_{p2}$, corresponding to a CO fault or a CP fault respectively. The voltage $V_{ref}$ may moreover be adjusted precisely. In fact, if it is not known how precisely to set the value of a resistor in an integrated circuit, it is, on the other hand, known how to precisely adjust a ratio of resistors such as those of the bridges $R_2$, $R_3$ and $R_4$, $R_6$. By setting the voltage $V_{ref}$ to a value midway between the voltages $V_{P1}$ and $V_{P2}$, for which the expressions were given above, the output of the comparator $C_1$ is prepared, while the transistor $T_1$ is non-conducting, for switching to one of its two logic states corresponding either to the detection of an open circuit, fault, or to the detection of a permanently on fault.

It will be noticed, however, that this detection relies on the prior detection of the existence of an "abnormal" state in the circuit supplying the load. In fact, in normal operation the output of the comparator $C_1$ has to be one of the two possible logic states, a situation which need not be taken to mean the presence of the fault associated with that state, according to the relationship described above.

Figure 2 of the attached drawing shows a first embodiment of the device according to the invention, supplemented by the addition of means making it possible to detect the existence of a normal or abnormal operating state in the circuit supplying the load $R_L$. This figure thus shows all the means represented in Figure 1, these means being supplemented by a comparator $C_2$ whose positive input is connected to the common terminal of the load $R_L$ and the transistor $T_1$ and whose negative terminal is connected to the midpoint S of a third resistor bridge $R_6$, $R_7$ connected between the voltage source $V_{CC}$ and earth.

If account is not taken of a possible short-circuit fault in the load, separately identified as has been seen above, a normal state in the supply circuit is characterised, while the transistor $T_1$ is non-conducting, by the presence of a voltage + $V_{bat}$ at the common terminal of the load and the transistor $T_1$. The presence of a nil voltage or voltage other than + $V_{bat}$ at this point, signifying an abnormal state in the supply circuit, is signalled at the output of the comparator $C_2$, due to the fixed voltage derived from the ratio of the resistances $R_6$, $R_7$, suitable for producing at S an appropriate reference voltage $V_{ref2}$. Thus there are available at the output of the comparators $C_1$ and $C_2$ all the data necessary to identify a CO or CP fault.

If the supply voltage $V_{CC}$ of the comparators $C_1$ and $C_2$ and the bridges $R_2$, $R_3$, and $R_4$, $R_6$ is of the order of 5 volts, as is the case with MOS technology for example, it is prudent to ensure protection of these comparators in view of the voltage + $V_{bat}$, whose nominal value is 12 volts and which is liable to vary within a wide range, as is well known among motor vehicle electronics specialists. The comparator $C_1$ may therefore be protected in the standard way by the resistor $R_1$ and a Zener protection diode $D_9$ shown in dotted lines between the positive input of the comparator $C_1$ and earth. In the same way, the comparator $C_2$ may be protected by a resistor $R_8$ and a protection diode $D_8$ shown in dotted lines and fitted like the resistor $R_1$ and the diode $D_9$. Great structural similarity is noticeable between the input circuits of the comparators $C_1$ and $C_2$, each of which have a remote resistor, at least one resistor bridge and a diode. This similarity is conducive to regrouping them in order to have no more than a single comparator in the device, as is the case with the second embodiment of the device according to the invention represented in Figure 3.

This figure shows the components of the device in Figure 1, supplemented by a logic circuit CL connected to the output of the comparator $C_1$ and by a transistor $T_2$ controlling the supply to the resistor bridge $R_2$, $R_3$ from the voltage source $V_{CC}$. In an MOS technology model, the transistor $T_2$ is of the PMOS type for a reason which will become apparent below. As in the embodiment in Figure 2 the resistor $R_1$ and a Zener diode $D_z$ protect comparator $C_1$.

The logic circuit CL comprises a first logic gate $P_1$ with two inputs driven respectively by a control signal IN of the transistor $T_1$ and by the output of the comparator $C_1$, and an output driving the clock input H of a bistable flip-flop FF whose "reset" input R is also driven by the signal IN. The output $\overline{Q}$ of this flip-flop drives the gate of the transistor $T_2$ while its output Q drives an input of a second logic gate $P_2$ whose other input is connected directly to the output of the comparator $C_1$. As represented the gates $P_1$ and $P_2$ are of the NOT-OR type (or NOR according to English terminology).

Now the operation of the device in Figure 3 is described, which is driven by the logic circuit to produce at the outputs of the gates $P_1$ and $P_2$ the information sought on the state of the load $R_L$ supply circuit. It will be noted straight away that when the transistor $T_1$ conducts under the control of a signal IN = 1 to supply the load, the application of the signal IN = 1 to the input R of the flip-flop has the effect of "initialising" the output Q of the flip-flop FF to zero, while the output $\overline{Q}$ passes to state 1 to cut off the transistor $T_1$ of PMOS type, as has been seen above. If IN passes now to the logic state 0 to cut off the transistor $T_1$ and permit detections and differentiations according to the invention in the absence of an open circuit or permanent on signal ("normal" state), on the OUT pin of the circuit CI there is:

$$V_{OUT} = + V_{bat}$$

Consequently the voltage on the positive input of the comparator $C_1$ is:

$$V_+ = [R_3/(R_1 + R_3)] \cdot V_{bat}$$

$V_+$ being limited by $V_z$, Zener voltage of the diode $D_z$ chosen for example equal to 5.2 volts to protect a comparator supplied at $V_{CC} = + 5$ volts.

In the case of a permanent on signal or an open circuit ("abnormal" state) there is $V_{OUT} = 0$ due to the fact of the bleed to earth established by the resistors $R_1$ and $R_3$. In the case of an abnormal state, there is therefore:

$$V_+ \simeq 0$$

In the two situations described above, on the negative input of the comparator $C_1$ there is:

$$V_- = [R_5/(R_4 + R_5)] \cdot V_{CC}$$

$V_-$ then being clearly positive and thus higher than the value of $V_+$ in the case of an abnormal state, the logic state at the output of the comparator $C_1$ can be associated with a normal or abnormal state. It is observed then that, in the case of an abnormal state the output of the logic gate $P_1$ is at 1 ($P_1 = \overline{IN.C_1}$) which drives the output $\overline{Q}$ of the flip-flop FF to 0, the transistor $T_2$ then becoming conducting to ensure the supply to the resistor bridge $R_2$, $R_3$ which will permit the discrimination between the CO and CP faults.

In effect, in the case of an open circuit CO fault:

$$V_+ = [R_3/(R_{2total} + R_3)] \cdot V_{CC}$$

while in the case of a permanent on fault there is:

$$V_+ = [R_3 R_1/(R_3 R_1 + R_{2total} R_3 + R_1 R_{2total})] \cdot V_{CC}$$

with $R_{2total} = R_2 + R_{T2}$, and $R_{T2}$ : resistance of the drain-source circuit of the transistor $T_2$ in the conducting state.

By holding the value of the voltage $V_-$ on the negative pin of the comparator $C_1$ at a value halfway between the two values $V_+$ expressed above, there is obtained at the output of the logic gate $P_2$ ($P_2 = \overline{Q}.\overline{C_1}$) a logic state signifying either the presence of an open circuit fault CO ($P_2 = 0$), or the presence of a permanent on fault CP ($P_2 = 1$). The logic circuit CL thus delivers at the outputs $\overline{Q}$ of the flip-flop FF and of the gate $P_2$ all the information necessary to identify a OC or CP fault namely:

> $\overline{Q}$ = 1, normal operation
> $\overline{Q}$ = 0, abnormal operation
> $P_2$ = 0, open circuit (CO)
> $P_2$ = 1, permanent on signal (CP)

By way of a non-limiting numerical example, if the following are chosen:

> $V_{CC}$ = 5 V
> $R_1$ = 25 kΩ
> $R_{2total}$ = 30 kΩ
> $R_3$ = 75 kΩ

the following values are obtained for $V_+$ :

- normal state : $V_+ = 0.75 \cdot V_{bat}$
- abnormal state : $V_+ = 0$
- CO fault : $V_+ = 0.71 \, V_{CC} = 3.55$ volts
- CP fault : $V_+ = 0.38 \, V_{CC} = 1.90$ volts

The ratio of the resistors $R_4$ and $R_5$ will then be adjusted such that $V_-$ is between 0.71 $V_{CC}$ and 0.38 $V_{CC}$, for example :

$$V_- = 0.6 \, V_{CC} = 3 \text{ volts}$$

It appears now that the invention permits the construction of a device for detecting and discriminating between open circuit and permanent on faults which permits the achievement of the stated objectives, namely full and certain discrimination of these faults with a circuit which does not require connection to the source of power for the load, a particularly advantageous arrangement when this device must be integrated into a "smart" power circuit controlling that load via its neutral terminal. Discrimination does not require reading the states of a comparator during a conducting and then a non-conducting state of the power transistor controlling the supply to the load in such an intelligent power circuit. Finally, integration of the device according to the invention poses no problem and permits easy attainment of the precision necessary due to the fact that only the ratios between resistors need to be adjusted.

## Claims

1. Device for detecting and discriminating between faults in the operation of a circuit supplying electric power to a load connected between a source of electrical energy (+ $V_{bat}$) and one terminal of an electronic switch ($T_1$) controlling the passage of a current in that load and through the switch ($T_1$), towards an earth connected to another terminal of the switch, this device comprising means for detecting, in the absence of a load supply on command, an abnormal state in the circuit supplying that load and means for then identifying a fault (CO) resulting from an open circuit in the supply circuit or a fault (CP) resulting from a short-circuit of the switch ($T_1$), which brings about a condition where the supply to the load is permanently on, these means of identification comprising a resistor ($R_1$) connected between the common terminal of the load and the switch and the midpoint (P) of a resistor bridge ($R_2$, $R_3$) connected between a voltage source ($V_{CC}$) and earth, and a comparator ($C_1$) for comparing the voltage at the midpoint of the bridge with a reference voltage ($V_{ref}$) in such a way as to diagnose the possible presence of an open circuit (CO) fault or permanently on (CP) fault in the circuit, according to the value of the voltage at the midpoint of the bridge compared with the reference voltage.

2. Device according to Claim 1, characterised in that the switch ($T_1$) forms part of a " smart " power circuit (CI) supplied by the voltage source ($V_{CC}$).

3. Device according to Claim 2, characterised in that it also comprises a second resistor bridge ($R_4$, $R_5$) connected between the voltage source ($V_{CC}$) and earth, the voltage at the midpoint (R) of this bridge ($R_4$, $R_5$) defining the reference voltage ($V_{ref}$), the resistors ($R_4$, $R_5$) being adjusted such that this voltage is between those which are observed at the midpoint (P) of the bridge ($R_2$, $R_3$) when the switch ($T_1$) is non-conducting, in the presence of an open circuit (CO) fault and of a permanently on (CP) fault, respectively.

4. Device according to any one of Claims 1 to 3, characterised in that the means for detecting an abnormal state in the power supply circuit comprise means ($R_5$, $R_7$, $C_2$) for comparing, while the switch ($T_1$) is non-conducting, the voltage ($V_{OUT}$) of the terminal common to this switch and the load ($R_L$), with a second reference voltage ($V_{ref2}$) in order to deduce from the value of the voltage ($V_{OUT}$) compared with this second reference voltage, a presence or art absence of an open circuit (CO) or a permanently on (CP) fault in the load supply circuit.

5. Device according to any one of Claims 1 to 3, characterised in that it comprises a second electronic switch ($T_2$) placed in the circuit of the resistor bridge ($R_2$, $R_3$) and a logic circuit (CL) connected to the output of the comparator ($C_1$) and controlling the second switch ($T_2$) in such a way as to effect a comparison with a reference voltage ($V_{ref}$) successively a) of the voltage present at the common terminal of the load and the switch ($T_1$) when that switch is non-conducting and, if this comparison reveals the presence of a fault in the circuit supplying that load, b) of the voltage of the midpoint (P) of the resistor bridge ($R_2$, $R_3$) after a voltage is applied to this bridge by the second switch ($T_2$), for the identification of the fault in question.

6. Device according to Claim 5, characterised in that the logic circuit (CL) comprises a first logic gate ($P_1$) driven by the comparator ($C_1$), a bistable flip-flop (FF) whose clock input (H) is connected to the output of the gate ($P_1$), this flip-flop driving via one output ($\overline{Q}$) the switch ($T_2$), and a second logic gate ($P_2$) driven by another output (Q) of the flip-flop and by the output of the comparator ($C_1$), the state of the output of the second logic gate identifying a possible fault (CO) or (CP) when the output state of the first gate ($P_1$) indicates the presence of one or the other of these faults.

7. Device according to Claim 6, characterised in that the gates ($P_1$) and ($P_2$) are of the NON-OR type.

8. Device according to any one of Claims 2 to 7, characterised in that it is integrated into the "smart" power circuit (CI).

**Patentansprüche**

1. Gerät zum Erfassen und Unterscheiden vqn Fehlern im Betrieb einer elektrischen Versorgungsschaltung für eine Last, die zwischen eine elektrische Energiequelle ($+V_{bat}$) und einen Anschlup eines elektronischen Schalters ($T_1$) angeschlossen ist, der den Strom durch die Last und durch den Schalter ($T_1$) zu Masse steuert, die an einen anderen Anschluß des Schalters angeschlossen ist, wobei das Gerät Mittel zum Erfassen eines anormalen Zustandes der Stromversorgungsschaltung bei Abwesenheit eines Laststroms auf Befehl und Mittel zum Identifizieren eines Fehlers (CO) als Folge einer Unterbrechung in der Stromversorgungsschaltung oder eines Fehlers (CP) als Folge eines Kurzschlusses des Schalters ($T_1$) aufweist, was zu einer Bedingung führt, in der die Stromversorgung für die Last ständig eingeschaltet ist, wobei diese Mittel zum Identifizieren einen Widerstand ($R_1$) aufweisen, der zwischen dem gemeinsamen Anschlup der Last und dem Schalter und dem Verbindungspunkt P einer Widerstandsbrücke $R_2$, $R_3$ liegt, die zwischen einer Spannungsquelle $V_{CC}$ und Masse liegt, sowie einen Vergleicher ($C_1$) aufweisen zum Vergleichen der Spannung am Verbindungspunkt der Brücke mit einer Bezugsspannung ($V_{ref}$) derart, daß das mögliche Vorhandensein eines Unterbrechungsfehlers (CO) oder eines permanenten Einschaltfehlers (CP) in der Schaltung gemäß dem Spannungswert am Verbindungpunkt der Brücke im Vergleich zur Bezugsspannung festgestellt wird.

2. Gerät nach Anspruch 1, dadurch gekennzeichnet, daß der Schalter ($T_1$) Teil einer "Smart"-Leistungsschaltung (CI) ist, die von der Spannungsquelle ($V_{CC}$) versorgt wird.

3. Gerät nach Anspruch 2, dadurch gekennzeichnet, daß es ferner eine zweite Widerstandsbrücke ($R_4$, $R_5$) aufweist, die zwischen der Spannungsquelle ($V_{CC}$) und Masse liegt, wobei die Spannung am Verbindungspunkt (R) der Brücke ($R_4$, $R_5$) die Bezugsspannung $V_{ref}$ definiert, die Widerstände ($R_4$, $R_5$) so eingestellt sind, daß diese Spannung zwischen den Werten liegt, die am Verbindungspunkt (P) der Brücke ($R_2$, $R_3$) herrschen, wenn der Schalter ($T_1$) nicht leitend ist bei Vorhandensein eines Unterbrechungsfehlers (CO) bzw. eines permanenten Einschaltfehlers (CP).

4. Gerät nach einem der Ansprüche 1 bis 3, dadurch gekennzeichnet, daß die Mittel zum Erfassen eines anormalen Zustandes in der Stromversorgung Mittel ($R_5$, $R_7$, $C_2$) aufweisen, um bei nichtleitendem Schalter ($T_1$) die Spannung ($V_{OUT}$) des dem Schalter und der Last ($R_L$) gemeinsamen Anschlusses mit einer zweiten Bezugsspannung ($V_{ref2}$) zu vergleichen, um aus dem Wert der Spannung ($V_{OUT}$) im Vergleich mit dieser zweiten Bezugsspannung ein Vorhandensein oder Nichtvorhandensein eines Unterbrechungsfehlers (CO) oder eines permanenten Einschaltfehlers (CP) in der Lastversorgungsschaltung abzuleiten.

5. Gerät nach einem der Ansprüche 1 bis 3, dadurch gekennzeichnet, daß es einen zweiten elektronischen Schalter ($T_2$) aufweist, der in der Schaltung der Widerstandsbrücke ($R_2$, $R_3$) angeordnet ist, sowie eine an den Ausgang des Vergleichers ($C_1$) angeschlossene Logikschaltung (CL) aufweist, die den zweiten Schalter ($T_2$) derart steuert, daß ein Vergleich mit einer Bezugsspannung ($V_{ref}$) nacheinander wie folgt ausgeführt wird:
   a) Spannung am gemeinsamen Anschluß der Last und des Schalters ($T_1$), wenn der Schalter nicht leitend ist und wenn dieser Vergleich das Vorhandensein eines Fehlers in der Lastversorgungsschaltung liefert,
   b) Spannung am Verbindungspunkt (P) der Widerstandsbrücke ($R_2$, $R_3$), nachdem eine Spannung von dem zweiten Schalter ($T_2$) an die Brücke geführt wird, um den fraglichen Fehler zu identifizieren.

6. Gerät nach Anspruch 5, dadurch gekennzeichnet, daß die Logikschaltung (CL) eine erste logische Torschaltung ($P_1$) aufweist, die von dem Vergleicher ($C_1$) angesteuert ist, sowie ein bistabiles Flipflop (FF), dessen Takteingang (H) an den Ausgang der Torschaltung ($P_1$) angeschlossen ist, wobei das Flipflop über einen Ausgang ($\overline{Q}$) den Schalter ($T_2$) ansteuert, und die ferner eine zweite logische Torschaltung ($P_2$) aufweist, die von einem anderen Ausgang (Q) des Flipflop und vom Ausgang des Vergleichers ($C_1$) angesteuert ist, wobei der Zustand am Ausgang der zweiten Torschaltung einen möglichen Fehler (CO) oder (CP) identifiziert, wenn der Ausgangszustand der ersten Torschaltung ($P_1$) das Vorhandensein des einen oder des anderen Fehlers anzeigt.

7. Gerät nach Anspruch 6, dadurch gekennzeichnet, daß die Torschaltungen ($P_1$) und ($P_2$) vom NON-OR-Typ sind.

8. Gerät nach einem der Ansprüche 2 bis 7, dadurch gekennzeichnet, daß es in einen "smarten" Leistungsschaltkreis (CI) integriert ist.

## Revendications

1. Dispositif de détection et de discrimination de défauts de fonctionnement d'un circuit d'alimentation électrique d'une charge connectée entre une source d'énergie électrique ($+ V_{bat}$) et une électrode d'un interrupteur électronique ($T_1$) commandant le passage d'un courant dans cette charge et à travers l'interrupteur ($T_1$) vers une masse connectée à une autre électrode de l'interrupteur, ce dispositif comprenant des moyens pour détecter, en l'absence de commande d'alimentation de la charge, un état anormal du circuit d'alimentation de cette charge et des moyens pour identifier alors un défaut (CO) résultant d'une ouverture du circuit d'alimentation ou un défaut (CP) résultant d'un court-circuit de l'interrupteur ($T_1$) qui entraîne une commande permanente de l'alimentation de la charge, ces moyens d'identification comprenant une résistance ($R_1$) connectée entre la borne commune à la charge et à l'interrupteur et le point milieu (P) d'un pont de résistances ($R_2$, $R_3$) connecté entre une source de tension ($V_{CC}$) et la masse, et un comparateur ($C_1$) pour comparer la tension au point milieu du pont à une tension de référence ($V_{ref}$) de manière à diagnostiquer la présence éventuelle d'un défaut (CO) de circuit ouvert ou de commande permanente (CP) suivant la valeur de la tension du point milieu du pont par rapport à la tension de référence.

2. Dispositif conforme à la revendication 1, caractérisé en ce que l'interrupteur ($T_1$) fait partie d'un circuit de puissance "intelligent" (CI) alimenté par la source de tension ($V_{CC}$).

3. Dispositif conforme à la revendication 2, caractérisé en ce qu'il comprend en outre un deuxième pont de résistances ($R_4$, $R_5$) connecté entre la source de tension ($V_{CC}$) et la masse, la tension du point milieu (R) de ce pont ($R_4$, $R_5$) définissant la tension de référence ($V_{ref}$), les résistances ($R_4$, $R_5$) étant ajustées pour que cette tension soit comprise entre celles que l'on observe au point milieu (P) du pont ($R_2$, $R_3$) alors que l'interrupteur ($T_1$) est bloqué, en présence d'un défaut de circuit ouvert (CO) et d'un défaut de commande permanente (CP), respectivement.

4. Dispositif conforme à l'une quelconque des revendications 1 à 3, caractérisé en ce que les moyens de détection d'un état anormal du circuit d'alimentation comprennent des moyens ($R_6$, $R_7$, $C_2$) pour comparer, alors que l'interrupteur ($T_1$) est bloqué, la tension ($V_{OUT}$) de la borne commune à cet interrupteur et à la charge ($R_L$), à une deuxième tension de référence ($V_{ref2}$) pour déduire de la valeur de la tension ($V_{OUT}$) par rapport à cette deuxième tension de référence, une présence ou une absence de défaut de circuit ouvert (CO) ou de commande permanente (CP) dans le circuit d'alimentation de la charge.

5. Dispositif conforme à l'une quelconque des revendications 1 à 3, caractérisé en ce qu'il comprend un deuxième interrupteur électronique ($T_2$) placé dans le circuit du pont de résistances ($R_2$, $R_3$) et un circuit logique (CL) connecté à la sortie du comparateur ($C_1$) et commandant le deuxième interrupteur ($T_2$) de manière à opérer une comparaison à une tension de référence ($V_{ref}$) successivement a) de la tension régnant à la borne commune à la charge et à l'interrupteur ($T_1$) quand cet interrupteur est bloqué et, si cette comparaison révèle la présence d'un défaut du circuit d'alimentation de cette charge, b) de la tension du point milieu (P) du pont de résistances ($R_2$, $R_3$) après mise sous tension de ce pont par le deuxième interrupteur ($T_2$), pour l'identification du défaut en cause.

6. Dispositif conforme à la revendication 5, caractérisé en ce que le circuit logique (CL) comprend une première porte logique ($P_1$) commandée par le comparateur ($C_1$), une bascule bistable (FF) dont l'entrée d'horloge (H) est connectée à la sortie de la porte ($P_1$), cette bascule commandant par une sortie ($Q^-$) l'interrupteur ($T_2$), et une deuxième porte logique ($P_2$) commandée par une autre sortie (Q) de la bascule et par la sortie du comparateur ($C_1$), l'état de la sortie de la deuxième porte logique identifiant un éventuel défaut (CO) ou (CP) lorsque l'état de la sortie de la première porte ($P_1$) indique la présence de l'un ou l'autre de ces défauts.

7. Dispositif conforme à la revendication 6, caractérisé en ce que les portes ($P_1$) et ($P_2$) sont du type NON-OU.

8. Dispositif conforme à l'une quelconque des revendications 2 à 7, caractérisé en ce qu'il est intégré au circuit de puissance intelligent (CI).

FIG.:1

FIG.:2

FIG.:3